# EUROPÄISCHE PATENTANMELDUNG

(11) **EP 2 242 340 A2**
(43) Veröffentlichungstag der Anmeldung: **20.10.2010**
(21) Anmeldenummer: 10003939.5
(22) Anmeldetag: 14.04.2010
(51) Int. Cl.: H05K 1/11

(54) **Vorrichtung zur Zufuhr elektrischer Energie an einen Verbraucher**

(30) Priorität: 14.04.2009 DE 202009005428 U
(71) Anmelder: Dula-Werke Dustmann & Co. GmbH, 44225 Dortmund (DE)
(72) Erfinder: Dustmann, Heinz-Herbert, 44225 Dortmund (DE); Meis, Alfons, 46286 Dorsten (DE)
(74) Vertreter: Patentanwälte Buse, Mentzel, Ludewig

(57) **Zusammenfassung**

Vorrichtung (10) zur Zufuhr elektrischer Energie an einen Verbraucher, wobei die Vorrichtung (10) aus einem Träger (21) mit mindestens einer aufgebrachten elektrisch leitfähigen Leitschicht (22) besteht. Der Träger (21) ist aus einem folienartigen Material hergestellt, und die auf dem Träger (21) angeordnete Leitschicht (22) ist aus einem Material hergestellt, was die Elastizität des Trägers (21) nicht einschränkt. Aufgrund dieser Elastizität der Vorrichtung (10) kann die Vorrichtung (10) auch in gebogenen oder geknickten Gehäusen eingepasst werden. Dazu besitzt die Vorrichtung (10) eine Kontur (17), die zumindest bereichsweise an die Kontur des Gehäuses angepasst ist.

## Beschreibung

Die Erfindung betrifft eine Vorrichtung zur Zufuhr elektrischer Energie an einen Verbraucher der im Oberbegriff von Anspruch 1 genannten Art.

Solche Vorrichtungen werden zur Kontaktierung von elektrischen Verbrauchern mit einer elektrischen Energiequelle bei vielerlei in Gehäusen eingebrachten Verbrauchern angewandt. Meist handelt es sich dabei um vorgefertigte Platinen, die den Großteil der Strecke zur Kontaktierung der Verbraucher überwinden. Letztendlich muss mindestens diese Platine mit entweder der Quellen- und/oder der Verbraucherseite mit einer Leitung verbunden werden. Eine Leitung wird deshalb eingesetzt, damit die Stromversorgung flexibel an den Verbraucher angepasst werden kann, um möglichst unsichtbar zu sein. Nachteilig bei dieser Art von Energieversorgung ist jedoch, dass der Verbraucher einzeln über die Leitungen mit der Stromquelle verbunden werden müssen. Hierzu reicht es oft nicht aus, Leitungen zur Verbindung zu benutzen, sondern diese müssen mit Steckern versehen werden, um eine sichere Kontaktierung zu gewährleisten.

Ein hoher Aufwand entsteht dann, wenn es sich um mehrere gleichartige Verbraucher handelt, die in einem System alle einzeln mit einer Stromquelle verbunden werden müssen. Da hier jedes einzelne Element des Systems mit der Stromquelle verbunden werden muss, entsteht ein hoher Kostenaufwand für die einzelnen Leitungen und Stecker sowie ein hoher Kontaktieraufwand durch das Stecken der einzelnen Leitungen.

Der vorliegenden Erfindung liegt also die Aufgabe zugrunde, eine Energiezufuhr zu einem Verbraucher zu realisieren, wobei die Vorrichtung zur Kontaktierung möglichst unsichtbar in dem Verbraucher integriert werden kann und die Kontaktierung des Verbrauchers mit der Stromquelle einen möglichst geringen Aufwand darstellt.

Diese Aufgabe wird durch das Kennzeichen des Anspruchs 1 gelöst. Die Vorrichtung besteht aus einem Träger mit mindestens einer aufgebrachten elektrisch leitfähigen Leitschicht. Diese Leitschicht bildet mindestens eine Leiterbahn. Der Träger ist aus einem folienartigen Material hergestellt, welcher eine hohe Elastizität bietet. Die auf dem Träger angeordnete Leitschicht ist aus einem Material hergestellt, was die Elastizität des Trägers nicht einschränkt.

Aufgrund der oben genannten Elastizität der Vorrichtung kann diese auch in gebogenen oder geknickten Gehäusen eingepasst werden. Dadurch erreicht man, dass die Vorrichtung nahezu unsichtbar in einem entsprechenden Gehäuse anbringbar ist.

Als Schutz gegen Umwelteinflüsse ist auf der Seite des Trägers, auf der die Leitschicht aufgetragen ist, zusätzlich eine Schutzschicht vorgesehen, die ebenfalls die Elastizität der Vorrichtung nicht einschränkt. Durch diese Schutzschicht verlängert man die Lebensdauer der Vorrichtung, da durch sie verhindert wird, dass die Leiterbahnen der Leitschicht beschädigt wird.

Auf der gegenüberliegenden Seite des Trägers von der Leitschicht aus gesehen ist eine Klebeschicht vorgesehen, mittels welcher die Vorrichtung in ein entsprechendes Gehäuse eingeklebt wird. Dies erleichtert die Anpassung der Vorrichtung an eventuelle Krümmungen oder Biegungen in dem Gehäuse und es erleichtert die Befestigung der Vorrichtung im Gehäuse. Somit besteht bevorzugterweise die Vorrichtung aus vier Schichten, nämlich einer Klebeschicht, die auf dem Träger aufgebracht ist, mindestens einer Leitschicht, die die Leiterbahn bildet und einer Schutzschicht. Alle vier Schichten zusammen sind so elastisch gehalten, dass die Vorrichtung sich die Oberfläche im Gehäuse anpasst.

Jeweils am Ende der Leiterbahnen der Leitschicht ist eine Kontaktfläche vorgesehen. Diese Kontaktfläche ist nicht von der Schutzschicht umfasst und kann somit zur freien Kontaktierung zur Übertragung elektrischer Energie genutzt werden. Diese Kontaktflächen sind bevorzugterweise breiter ausgeführt als die Leiterbahnen, die an die Kontaktflächen angeschlossen sind. Dies begünstigt ein einwandfreies Kontaktieren.

Die Vorrichtung selber ist zumindest bereichsweise der Kontur des Gehäuses, in welche sie eingebracht wird, nachempfunden, so dass beispielsweise bei einem Ladenbausystem, bei dem die einzelnen Regalböden über das Regal mit elektrischer Energie versorgt werden müssen, durch einfaches Einhängen der Regalböden in das Regalsystem kontaktiert werden.

Diese Kontaktierung beim Einhängen geschieht auf der Quellenseite, das bedeutet, dass die Seite, über die der einzelne Verbraucher mit elektrischer Energie versorgt wird, in das Regal eingehangen wird. Das Regal ist dabei so konzipiert, dass die Kontakte zur Übertragung der elektrischen Energie direkt auf die Kontaktflächen zugreifen. Die Verbraucher innerhalb des Regalbodens greifen ihrerseits durch die verbraucherseitigen Kontaktflächen in der Vorrichtung zu.

Bevorzugterweise sind Rastnasen in der Kontur der Vorrichtung vorgesehen, so, wie sie auch im Gehäuse des Verbrauchers vorgesehen sind, um den Verbraucher einfach in ein System einzuhängen.

Durch diese Art der Kontaktierung ist es nicht notwendig, Leitungen und/oder Stecker zur Kontaktierung zu benutzen.

Weitere Vorteile der vorliegenden Erfindung ergeben sich aus den nachfolgenden Zeichnungen sowie der Beschreibung dazu. Es zeigen:
- Fig. 1: eine Draufsicht auf eine Vorrichtung mit zwei Leiterbahnen,
- Fig. 2: eine Frontalansicht auf die Vorrichtung aus Fig. 1,
- Fig. 3: eine perspektivische Darstellung der Vorrichtung aus Fig. 1.

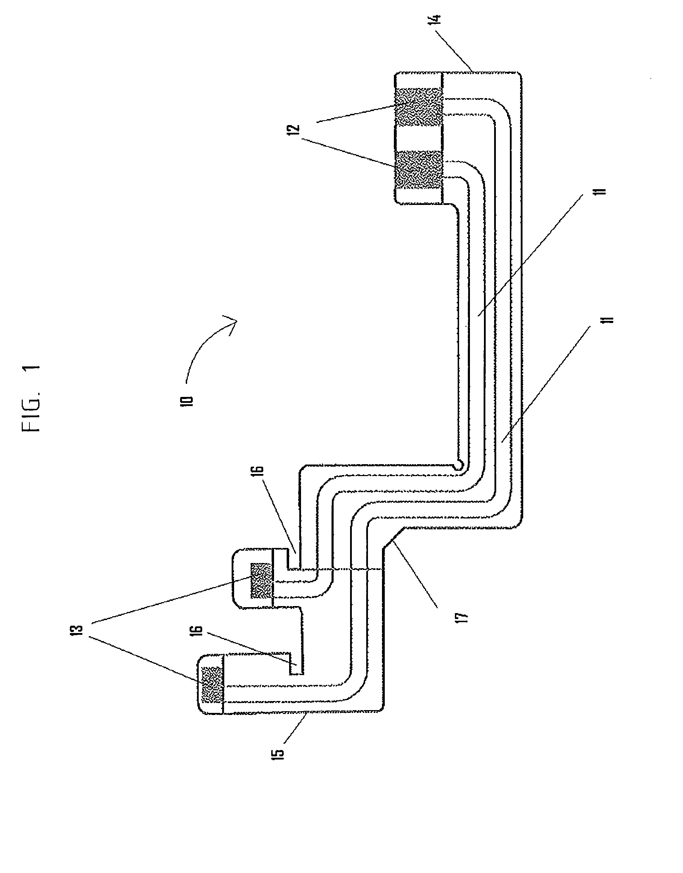

In Fig. 1 sieht man eine Vorrichtung 10 mit zwei Leiterbahnen 11 in der Leitschicht 22, an deren Ende jeweils eine Kontaktfläche 12, 13 angeschlossen ist. Diese Kontaktfläche dient zur Kontaktierung von Verbraucher und Quelle. Somit sind zwei Kontaktflächen verbraucherseitig 12 angeordnet sowie zwei Kontaktflächen quellseitig 13. Die Kontur 17 der Vorrichtung 10 ist auf ein Ladenbausystem zugeschnitten, wobei die Vorrichtung 10 in die Böden des Ladenbausystems eingebracht werden sollen. Somit ist die Kontur 17 der Gehäuseform der einzelnen Böden im Ladenbausystem nachempfunden. Durch die Elastizität der Vorrichtung 10 kann diese auch in Bögen bzw. in Randbereichen mit Knicken eingebracht werden.

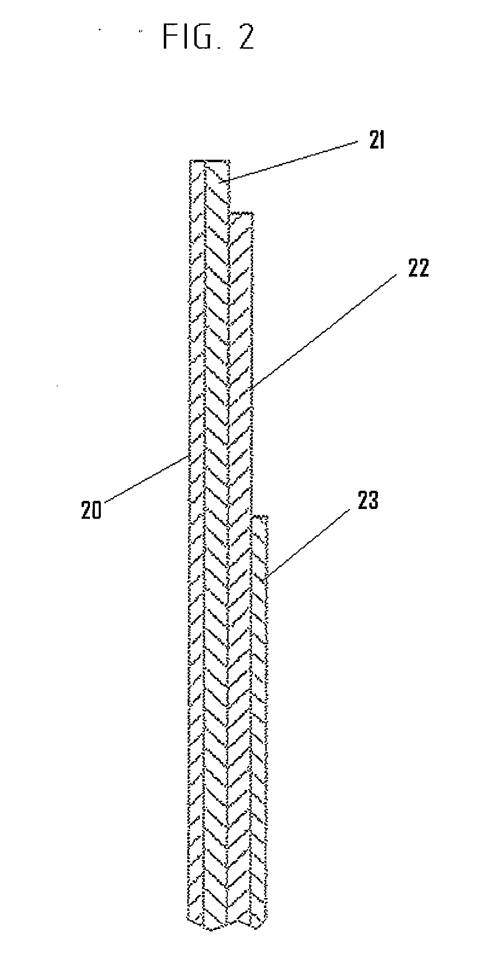

Die Vorrichtung 10 selber besteht aus vier Schichten, die in Fig. 2 dargestellt sind. Diese vier Schichten sind ein transparenter Träger 21, auf dessen einer Seite eine Klebeschicht 20 angebracht wird, um die Vorrichtung 10 in einem entsprechenden Gehäuse anzubringen. Auf der gegenüberliegenden Seite des Trägers 21 ist die Leitschicht 22 angebracht, auf der die Leiterbahnen 11 verlaufen. Auf die Leitschicht 22 wird eine Schutzschicht 23 aufgebracht, um die Leitschicht 22 und/oder den Träger zu schützen. Das Aufbringen der Schutzschicht 23 geschieht jedoch nur bereichsweise, da zumindest die Kontaktflächen verbraucherseitig 12 sowie quellenseitig 13 nicht von der Schutzschicht 23 überzogen sein dürfen, da auch die Schutzschicht 23 elektrisch isolierend wirkt und die Kontakte 12, 13 sonst nicht kontaktierbar wären. Alle vier Schichten zusammen ergeben die Vorrichtung 10 und sind elastisch ausgebildet.

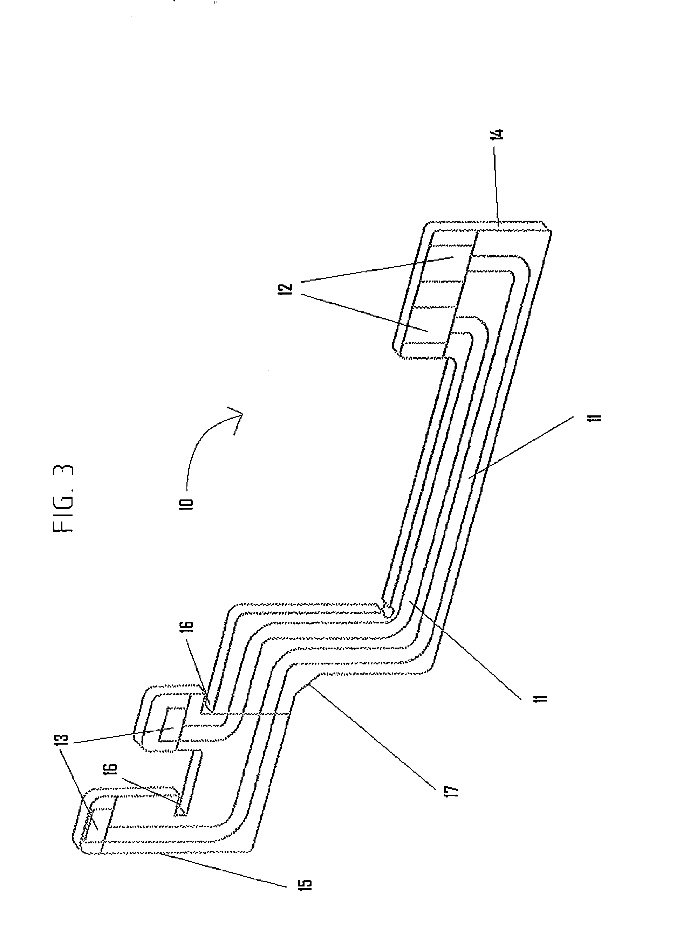

In Fig. 3 ist die Vorrichtung 10 der vorangegangenen Figuren perspektivisch dargestellt, wobei nochmals jedes einzelne Element aufgezeigt ist. Nach dem Anbringen der Vorrichtung 10 in ein entsprechendes Gehäuse kann durch die Elastizität der Vorrichtung 10 dieselbe auf jegliche geformte Oberfläche aufgebracht werden. Durch die Klebeschicht 20 ist eine einfache Montage im Gehäuse auf der Oberfläche möglich und die Kontur 17 der Vorrichtung 10 sollte zumindest bereichsweise der Kontur des Gehäuses entsprechen, um eine einfache Kontaktierung zu ermöglichen.

Zu der Konturform eines entsprechenden Gehäuses im Ladenbausystem gehört mindestens eine Rastnase 16, um den Regalboden, der das Gehäuse bildet, in ein entsprechendes System einzuhaken. Bei dem Einhakvorgang geschieht die Kontaktierung quellenseitig 15, da hierbei die Kontaktflächen quellenseitig 13 in das Regalsystem eingehangen werden und über entsprechende Mittel mit elektrischer Energie versorgt werden. Auf der Verbraucherseite 14 im Gehäuse des Regalbodens wird die Elektronik über die Kontaktflächen auf der Verbraucherseite 12 mit elektrischer Energie versorgt.

Die vorliegende Erfindung ist nicht auf die Ausführungsbeispiele beschränkt, sondern es sind vielmehr noch weitere Merkmale denkbar. So kann z.B. die Klebeschicht der Träger oder die Schutzschicht jeweils transparent realisiert sein oder nicht transparent. Die Kontaktflächen verbraucher- und quellenseitig können eine bestimmte Form annehmen, um spezielle Kontaktierungen zu ermöglichen. Die Leitschicht, die die Leiterbahnen enthält, kann aus verzinkter Kupferfolie hergestellt sein. Die Klebeschicht kann weggelassen werden und die Vorrichtung kann mittels Klemmverbindungen im Gehäuse angebracht werden.

### Bezugszeichenliste

- 10: Vorrichtung
- 11: Leiterbahn
- 12: Kontaktfläche, verbraucherseitig
- 13: Kontaktfläche, quellenseitig
- 14: Verbraucherseite
- 15: Quellenseite
- 16: Rastnase
- 17: Kontur
- 20: Klebeschicht
- 21: Träger
- 22: Leitschicht
- 23: Schutzschicht

## Patentansprüche

1. Vorrichtung (10) zur Zufuhr elektrischer Energie an einen Verbraucher,
mit einem Träger (21), der mindestens eine elektrisch leitfähige Leiterbahn (11), trägt,
mit jeweils wenigstens einer elektrisch leitfähigen Kontaktfläche (12, 13) der Leiterbahn an der Quellenseite (15) und an der Verbraucherseite (14), über welche die Quelle bzw. der Verbraucher kontaktierbar sind,
mit einem Gehäuse, in welches die Vorrichtung (10) einbringbar ist,
**dadurch gekennzeichnet,**
**dass** der Träger (21) als Trägerfolie aus elektrisch isolierendem Material ausgebildet ist, worauf mindestens eine elektrisch leitfähige Leitschicht (22) angeordnet ist, welche die Leiterbahn (11) bildet,
**dass** dieser Träger (21) eine geringe Steifigkeit besitzt, so dass er sich an unterschiedliche Gehäuseformen, anpasst
und **dass** dieser Träger (21) eine Kontur (17) besitzt, die zumindest bereichsweise an die Kontur des Gehäuses angepasst ist.

2. Vorrichtung (10) nach Anspruch 1, **dadurch gekennzeichnet, dass** die Leiterbahn (11) aus verzinnter Kupferfolie besteht.

3. Vorrichtung (10) nach Anspruch 1, **dadurch gekennzeichnet, dass** die Leiterbahn (11) aus Graphit besteht.

4. Vorrichtung (10) nach einem der Ansprüche 1 bis 2, **dadurch gekennzeichnet, dass** eine elektrisch isolierende Schutzschicht (23) zumindest bereichsweise auf dem Träger (21) und/oder der Leiterbahn (11) aufgebracht ist.

5. Vorrichtung (10) nach einem der Ansprüche 1 bis 4, **dadurch gekennzeichnet, dass** der Träger (21) transparent ist.

6. Vorrichtung (10) nach einem der Ansprüche 1 bis 5, **dadurch gekennzeichnet, dass** auf der Seite des Trägers (21), die sich gegenüber der Leitschicht (22) befindet, eine Klebeschicht (20) aufgebracht ist.

7. Vorrichtung (10) nach einem der Ansprüche 1 bis 6, **dadurch gekennzeichnet, dass** die Klebeschicht (20) transparent ist.

8. Vorrichtung (10) nach einem der Ansprüche 1 bis 7, **dadurch gekennzeichnet, dass** die Schutzschicht (23) transparent ist.

9. Vorrichtung (10) nach einem der Ansprüche 1 bis 8, **dadurch gekennzeichnet, dass** die Kontur (17) der Klebe- (20) und/oder Schutzschicht (23) und/oder des Trägers (21) mindestens eine Rastnase (16) vorsieht, durch welche die in das Gehäuse eingebrachte Vorrichtung (10) in eine entsprechenden Einrichtung einhakbar ist.

10. Vorrichtung (10) nach einem der Ansprüche 1 bis 9, **dadurch gekennzeichnet, dass** die Kontaktflächen (12, 13) rechteckig ausgeführt sind.

11. Vorrichtung (10) nach einem der Ansprüche 1 bis 10, **dadurch gekennzeichnet, dass** die Kontaktflächen (12, 13) breiter ausgeführt sind, als die angeschlossenen Leiterbahnen (11).
